# EUROPEAN PATENT SPECIFICATION

(11) **EP 0 819 473 B1**
(45) Date of publication and mention of the grant of the patent: **25.09.2002**
(21) Application number: 97305311.9
(22) Date of filing: 16.07.1997
(51) Int. Cl.: B05B 7/08, B05C 5/02

(54) **Method and apparatus for applying a liquid coating in atomised or non-atomised form by use of a single nozzle**
Verfahren und Vorrichtung zum Auftragen eines flüssigen Beschichtungsmittels in atomisierter oder nichtatomisierter Form mittels einer einzigen Düse
Procédé et appareil pour l'application d'un revêtement fluide atomisé ou non-atomisé en utilisant une seule buse

(30) Priority: 19.07.1996 US 687790; 19.06.1997 US 878756
(43) Date of publication of application: 21.01.1998
(73) Proprietor: NORDSON CORPORATION, Westlake, Ohio 44145-1119 (US)
(72) Inventor: Hogan, Patrick Thomas, Lorain, Ohio 44053 (US); Selestak, David M., Avon, Ohio 44011 (US); Zakrajsek, Richard, Lorain, Ohio 44052 (US); Donges, William E., Wellington, Ohio 44055 (US); Havlik, Chris, Elyria, Ohio 44035 (US); Harrell, Greg, Clyde, Ohio 43410 (US); Omilion, Zygmunt Carl, Parma, Ohio 44137 (US); Fox, Kevin, Avon Lake, Ohio 44012 (US)
(74) Representative: Findlay, Alice Rosemary

(56) References cited:
- EP-A- 0 293 065
- EP-A- 0 362 548
- EP-A- 0 578 084
- EP-A- 0 584 973
- WO-A-91/12088
- US-A- 5 382 312

## Description

This invention relates to applying a liquid to a substrate either as an atomized or nonatomized spray pattern. More particularly, the invention relates to an improved method and apparatus for selectively applying a coating of material on desired regions of a substrate such as a circuit board while avoiding the deposit of coating material on regions to be left uncoated.

Typically, circuit boards that require protection from moisture, electric leakage and dust are coated with moisture proof insulative films, known as conformal coatings, such as, acrylic, polyurethane, silicone or epoxy synthetic resins dissolved in a volatile solvent. When applied to clean circuit boards, an insulative resin film of uniform thickness and without pinholes, is formed as the solvent evaporates.

Spraying is the most commonly used insulative coating method employed in mass production. Spraying can be categorized as either air spraying in which an air stream is impinged against the stream of liquid coating material after leaving the spray nozzle to form an atomized spray pattern, or airless spraying in which the coating material is dispensed as a nonatomized spray pattern, as is disclosed in U.S. Patent No. 5,294,459, assigned to Nordson Corp.

In airless spraying of conformal coating material, as described in the 5,294,459 patent, the coating material is sprayed onto a circuit board as a flat, nonatomized pattern. Relative movement is effected between the nozzle and the circuit board in a direction transverse to the plane of the flat pattern discharged from the nozzle. The supply of coating material to the nozzle is intermittently interrupted so as to prevent a deposit of liquid coating on regions of the circuit board and/or circuit components which are to be left uncoated.

While air spraying, in which an air stream is impinged against the stream of liquid coating material to atomize the material after leaving the spray nozzle, as disclosed in the 5,294,459 patent, has proven to be an effective means of applying the material to a substrate, there is still some overspray which increases the production costs of the circuit boards. Even with airless spraying, the distance of the nozzle to the circuit board sometimes causes the coating material to coat regions which are to be left uncoated.

WO91/12088 describes a method and apparatus for deflecting a liquid stream during dispensing by directing air from a plurality of blowout ports. The liquid stream may be deflected to achieve a desired dot or spray distribution pattern on a substrate. The liquid may be dispensed as drops, droplets or atomized particles rather than a liquid stream.

The present invention provides a system for spray coating a substrate with a liquid coating material, comprising a liquid spray device having a liquid delivery passageway for supplying liquid coating material and an air delivery passageway for supplying pressurized air, a nozzle mounted to the liquid spray device having a discharge outlet at one end and having a throughbore in flow communication with the liquid delivery passageway to discharge the liquid coating material as a bead of liquid coating material from the discharge outlet, the nozzle including a plurality of air bores in flow communication with the air delivery passage to direct pressurized air against the outer periphery of the bead of liquid coating material discharged from the discharge outlet to form the liquid coating material into an atomized spray pattern, and a controller operatively connected to the liquid spray device for selectively opening and closing the air delivery passageway of the liquid spray device whereby the bead of liquid coating material discharged from the discharge outlet is applied to the substrate either as an atomized, spray pattern or as a bead of the liquid, characterised in that the plurality of air bores direct pressurized air such that the liquid coating material swirls within the atomized spray pattern.

Thus, the invention provides a system, and also methods, for coating substrates, such as circuit boards, with either a bead or an atomized conical, or a swirling spray pattern of liquid coating material discharged from a nozzle mounted to a liquid spray device. This obviates the problems and limitations of the prior art systems.

In a preferred embodiment, there is provided an apparatus and method having three modes of operation for selectively coating substrates, such as circuit boards, with either a bead of liquid coating material dispensed through an elongated nozzle tip or with an atomized, conical spray pattern formed by directing jets of relatively high pressurized air against the bead of liquid coating material dispensed through the elongated nozzle tip, or with a non-atomized, soft-swirling spray pattern formed by directing jets of relatively low pressurized air against the bead of liquid coating material dispensed through the nozzle.

A portion of the jets of pressurized air may be directed against the bead of liquid coating material dispensed through the elongated nozzle tip and a portion of the pressurized air against the nozzle tip to stabilize the nozzle tip.

In another embodiment the volume of residual coating present in the throughbore is minimized, consequently minimizing or substantially eliminating drip and dribble during startup.

A first embodiment of a system and method for spray coating a substrate with a liquid coating material includes a nozzle having an elongated nozzle tip extending outwardly therefrom. Each of the bores is formed at an angle with respect to the throughbore to direct pressurized air against both the elongated nozzle tip and the outer periphery of the bead of liquid coating material discharged from the elongated nozzle tip to form the liquid coating material into an atomized, conical swirling spray pattern.

In a second embodiment the system and method of the first embodiment can be used with a nozzle constructed without the elongated nozzle tip.

In a third embodiment pressurized air supplied to the spray nozzle is diverted to an exhaust port when operating the spray gun in a non-pressure-assisted mode of operation.

In a fourth embodiment pressurized air supplied to the spray nozzle is reacted by a fluid damping system when initiating operation of the spray gun in a pressure-assisted mode of operation.

This minimizes pressure spikes when initiating a pressure-assisted mode of operation, consequently minimizing or substantially eliminating splatter during startup.

The invention will now be further described by way of example only with reference to the accompanying drawings in which:
Fig. 1 is a side view, partly in cross section, of a coating system having an elongated nozzle with a plurality of air bores disposed thereabout in accordance with the present invention;
Fig. 2 is a top view of the nozzle with air bores;
Fig. 3 is a view, in cross section, through line 3-3 of Fig. 2;
Fig. 4 is a top view of a circuit board having a band of coating material applied as an atomized conical spray pattern when the coating system is operating in a first mode and a bead of coating material applied when the coating system is operating in a second mode;
Fig. 5 is a second embodiment of a spray nozzle adapted for use with the coating system of the present invention;
Fig. 6 is an alternative design of a nozzle with six air bores;
Fig. 7A is an illustration of a pattern of coating material applied onto a substrate in a first (atomizing) mode of operation, according to the invention;
Fig. 7B is an illustration of a pattern of coating pattern applied onto a substrate in a third (soft swirl) mode of operation, in accordance with the invention;
Fig. 7C is an illustration of a pattern of coating pattern applied onto a substrate in the third (soft swirl) mode of operation, in accordance with the invention;
Fig. 8 is a cross-sectional view of a portion of an embodiment of a coating system, according to the invention;
Fig. 9 is a graph illustrating the buildup of air pressure when operating the spray gun of the present invention;
Fig. 9A is a schematic illustration of an embodiment of a soft start aspect of the invention;
Fig. 9B is a schematic illustration of another embodiment of a soft start aspect of the invention; and
Fig. 9C is a graph illustrating the buildup of air pressure when operating the spray gun of the present invention using the soft start techniques of the invention.

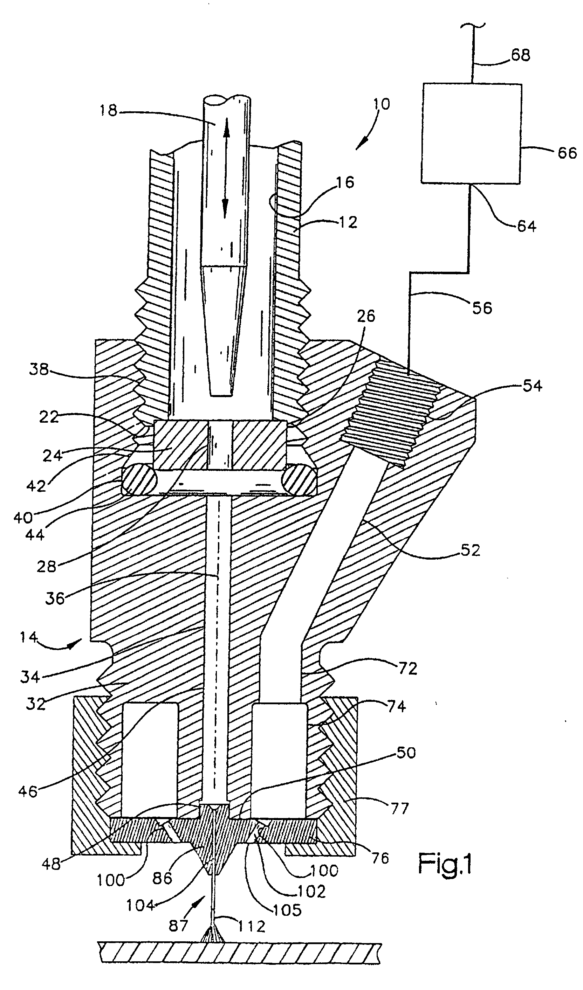

Referring to Fig. 1, a coating system 10 for selectively coating a substrate 11, typically a circuit board, with a moisture proof, insulative material is illustrated. The coating system 10 includes a spray gun (not shown) having a cylindrical extension (barrel) 12 with a nozzle assembly 14 attached thereto. The overall construction of the coating system 10 including a spray gun, a source of air and a source of coating material forms no part of this invention per se and is described only briefly herein. The nozzle assembly 14 could be attached, for example, to the threaded end of extension of a spray gun, such as the spray gun disclosed in U.S. Patent No. 5,294,459. The spray gun is operated by a conventional robot which controls the movement of the spray gun in the x, y and z axes.

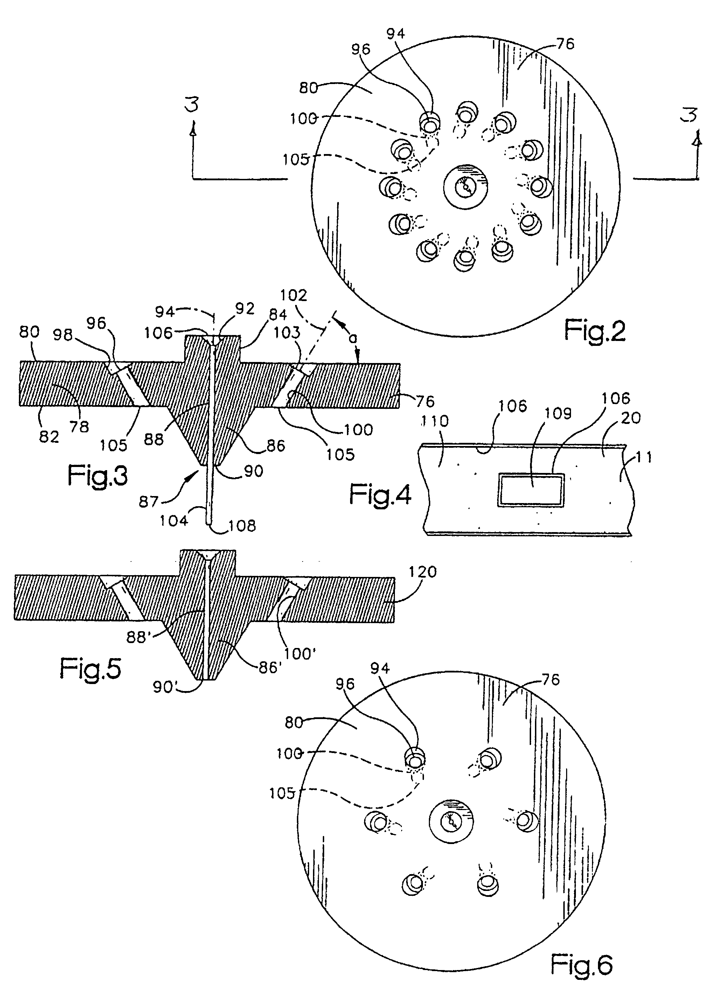

The cylindrical extension 12 has a throughbore 16 housing a reciprocating valve shaft 18 therein. Throughbore 16 is connected to a source (not shown) of pressurized, coating material 20 (see Fig. 2). The coating material includes a wide range of materials having a viscosity range of about 10 cps (centipoise) to about 1000 cps. The system is most advantageously used with conformal material which is either solvent free or has a low percentage of solvents. However, it may be used with conformal coating material with any typical percentage of solvents, generally known in the industry or to spray other types of liquid or viscous materials, as desired.

The coating material 20 is introduced into throughbore 16 at one end of cylindrical extension 12 and flows along the outside of valve shaft 18 and through the outlet end 22 of extension 12. The lower end of valve shaft 18 is preferably tapered and formed to engage a valve seat 24 located in a counterbore 26 formed at the lower end of throughbore 16, adjacent outlet end 22 of cylindrical extension 12. The valve shaft 18 reciprocates between an open, retracted open position, as shown in Fig. 1, in which its lower end disengages from valve seat 24 and opens a discharge outlet 28 therein, and an extended closed position (not shown) in which the lower end of valve shaft 18 engages seat 24 and blocks the discharge outlet 28. The opening and closing of discharge outlet 28 controls the discharge of coating material from throughbore 16 and into nozzle assembly 14 for deposition onto a substrate 11, such as a circuit board.

Referring to Fig. 1, the nozzle assembly 14 includes a nozzle support 32 has a stepped throughbore 34 centered about a vertical centerline 36. Throughbore 34 has an upper, threaded bore section 38 which mates with the external threads on the lower end of extension 12. Throughbore 34 has a second bore section 40, below threaded bore section 38 and adjoined thereto by an outwardly sloped frustro-conical surface 42. Second bore section 40, as illustrated in Fig. 1, is adapted to carry a seal 44, such as an O-ring, which engages seat 24 and forms a fluid tight seal between nozzle assembly 14 and cylindrical extension 12. Throughbore 34 has a third bore section 46, between second bore section 40 and a counterbore 48 disposed adjacent the outlet end 50 of nozzle support 32.

The nozzle support 32 has an air inlet bore 52 disposed on one side of throughbore 34. Inlet bore 52 has an inlet section 54 connected to an air line 56. Air line 56 is connected to the outlet port 64 of a controller, such as a solenoid actuated valve 66. Valve 66 is connected by an air line 68 to a source of pressurized gas, typically air. Opening and closing valve 66 by an external control (not shown), controls the air jets impinging against the coating material being discharged from nozzle support 32. Inlet bore 52 has an outlet section 72 connected to a ring shaped outlet port opening 74 at the outlet end 50 of nozzle support 32.

Nozzle assembly 14 includes a spray nozzle 76 disposed at the outlet end 50 of the nozzle support 32 and removably secured thereto with a nozzle nut 77 that is threadably secured to the threaded lower end of nozzle assembly 14, as shown in Fig. 1. Referring to Figs. 1, 2 and 3, the spray nozzle 76 is shown in detail. Spray nozzle 76 is an annular plate 78 having one side formed with a first or upper surface 80 and an opposite side formed with a second or lower surface 82 spaced from the upper surface 80. A boss 84 extends outwardly from the upper surface 80, and an nozzle head 86 extends outwardly from the lower surface 82 concentric to boss 84. A throughbore 88 is formed in spray nozzle 76 between the boss 84 and nozzle head 86 which has a discharge outlet 90. Spray nozzle 76 is mounted against the outlet end 50 of nozzle support 32 so that boss 84 extends into counterbore 48 of throughbore 34. The inlet end 92 of throughbore 88 is formed with a radially inwardly tapering sidewall relative to the longitudinal axis 94 of throughbore 88 and has a generally frustro-conical shape. An annular, V-shaped groove 96 is formed in the upper surface 80 of spray nozzle 76 and extends inwardly toward the lower surface 82. Groove 96 is in flow communication with outlet port 74. As shown in Figs. 2 and 3, twelve air jet bores 100 with a longitudinal axis 102 are formed in annular plate 78. Bores 100 have an inlet opening 103 intersecting annular groove 96 and an outlet opening 105 intersecting lower surface 82 at 30 degree intervals there along. In the preferred embodiment, the bores 100 have a diameter from about 0.013 inches (13 mils) (0.3302 mm) to about 0.024 inches (24 mils) (0.6096 mm). Preferably, as illustrated in Fig. 3, the longitudinal axis 102 through each air jet bore 100 is formed at an angle "a" of approximately 30 degrees with respect to the longitudinal axis 94 of the throughbore 88. However, it is within the terms of the invention to change the angle "a" to accommodate nozzle tips 86 of different sizes. Also, while the illustrated embodiment is described with twelve, equally spaced jet bores 100, it is within the terms of the invention to use six or more equally spaced jet bores 100, as shown in Fig. 6.

In one embodiment, nozzle head 86 has an elongated nozzle tip 87 constructed of a tube 104 having an inlet end 106 and an outlet end 108, and is mounted in throughbore 88 and secured therein by conventional means such as brazing. Inlet end 106 of tube 104 preferably extends to the intersection of inlet end 92 and throughbore 88. Outlet end 108 extends outward from the discharge outlet 90 of nozzle head 86 and terminates in a nozzle orifice 107. In the preferred embodiment, tube 104 extends a distance of about 0.250 inches (6.35 mm) to about 1.0 inches (25.4 mm) from discharge outlet 90. A bore extending through tube 104 of about 0.008 inches (0.2032 mm) to about 0.050 (1.27 mm) inches in diameter terminates with a nozzle orifice 107. While tube 104 is shown as being mounted within bore 88 of spray nozzle 76, nozzle 76 may be manufactured with tube 104 as a unitary element.

As shown in Fig. 1, the longitudinal axis 102 through each of the air jet bores 100 is angled to intersect both a portion of tube 104 projecting outward from discharge end 90 as well as a bead 112 of coating material 20 discharged from the outlet end 108 of the tube. The air flow from jet bores 100 is directed against tube 104 acts to stabilize the tube and reduce any vibration thereof. As discussed in detail below, the jets of air passing through each of the equally spaced air jet bores 100 impact the outside of the bead 112 of coating material 20 to atomize coating material 20 and to cause the atomized coating material to form a conical spray pattern for deposition onto substrate 11. In addition, the jets of air cause the atomized coating material to swirl within the conical spray pattern. Depending on the length of the section of tube 104 which projects from outlet 90, the angle of axis 102 with respect to axis 94 extending through bore 88 can be increased or decreased to control the proportion of air flow impingement against elongated nozzle tip 87 and against bead 112. Also, the spacing of the outlets 105 of jet bores 100 can be spaced closer or further from axis 94 through throughbore 88 as required to further control the proportion of air flow impingement against elongated nozzle tip 87 and against bead 112.

A flow path for coating material 20 extends from cylindrical extension 12 to the nozzle assembly 14 which includes throughbore 16 in extension 12, the discharge outlet 28 of valve seat 24, the throughbore 34 in nozzle assembly 14 and the bore through elongated nozzle tip 87 terminating in orifice 107, respectively. The flow of coating material through this flow path is controlled by valve shaft 18 moving between a retracted, open position relative to discharge outlet 28 in valve seat 24, and a closed, extended position relative to discharge outlet 28.

The system 10, typically used for spraying a circuit board 11 with coating material 20, has two modes of operation for applying the coating material to selective areas of the circuit board without applying the coating material to regions that are to be left uncoated. In a first mode when the air jets are directed against the bead of coating material being discharged from the nozzle orifice 107 of elongated nozzle tip 87, a high quality, pin hole free, thin coating of material between about 0.5 mils (0.0005 inches) (0.0127 mm) and about 5 mils (0.005 inches) (0.127 mm) can be applied to substrate 11. In a second mode when the air jets are turned off, a bead of coating of material between about 5 mils (0.127 mm) and about 10 mils (0.254 mm) can be applied to substrate 11.

In the first mode of operation, valve 66 opens to direct jets of air through air bores 100. Next, the flow of liquid coating material is initiated by moving valve. shaft 18 from an extended, closed position relative to discharge outlet 28 in valve seat 24, to an open, retracted position relative to discharge outlet 28. The liquid coating material now flows from a source (not shown) into throughbore 16 in extension 12, through discharge outlet 28 of valve seat 24, through throughbore 34 in nozzle assembly 14, through tube 104 and exits from nozzle orifice 107 of elongated nozzle tip 87 as a bead 112 of coating material. The pressure of the liquid coating material delivered to cylindrical extension 12, in the first mode, is about 5 psi (pounds per square inch) (34.47 kPa) to about 60 psi (413.68 kPa) and preferably between about 10 psi (68.947 kPa) and 30 psi (206.84 kPa). The jets of air impinge substantially tangential to the outer periphery of bead 112 of coating material discharged from nozzle orifice 107 of elongated nozzle tip 87 to break the liquid coating material into droplets and form an atomized spray having a generally conical shape, as illustrated in Fig. 1. In the first mode of operation, the air is delivered at a pressure of about 10 psi (68.947 kPa) to about 70 psi (482.63 kPa) and preferably about 10 psi (68.947 kPa) to about 20 psi (137.894 kPa). The atomized spray has a tendency to swirl within the conical shape because of the direction with which the bead of liquid material discharged from the nozzle is impinged from opposing sides by jets of pressurized air from air bores 100 and thereby forms a denser coating on the board. Typically, during application of the coating material 20, the board 11 is held in a stationary position and the robot to which the spray gun is mounted moves the gun in a preprogrammed pattern. A particular advantage is that the robot can move in the z axis so that the end 108 of tube 104 is positioned very close to the circuit board, i.e. about 0.250 inches (6.35 mm) to about 1.0 inches (25.4 mm) from substrate 11, so that the atomized conical spray pattern is tightly controlled and can be applied near the edges of the circuit board 11 or close to a circuit component 109 mounted to the upper surface 110 of the board. While the first mode of operation is effective for general spraying of circuit boards, a small, but noticeable overspray and splatter is sometimes produced by the conical spray pattern and prevents the use of air impingement when spraying the coating material along the edge of the board or directly adjacent to a region (typically having a circuit component such as a switch) which is to be left uncoated.

Under the latter circumstances, the second mode of operation is employed wherein the air valve 66 is closed and the coating material is applied as a nonatomized bead 112. In the second mode of operation, the coating material is delivered to cylindrical extension 12 at a pressure of about 30 psi (206.84 kPa) to about 60 psi (413.68 kPa). A particular advantage is the ability of the robot to move the end 108 of tube 104 very close to the circuit board 11. For example, when a circuit element 109 projects upward from the upper surface 110 of circuit board 11, as shown in Fig. 4, tube 104 can be positioned very close to the board so that the bead 112 of coating material is applied directly adjacent the circuit element without any contact with the coating material. Then, the robot can raise the end 108 of tube 104 away from surface 110 so that the tube can move across element 109 without any interference therewith. In selected applications, the bead 112 can also be applied along the edges of circuit board 11.

It can be appreciated by one skilled in the art that the two mode system described above is adapted for use with a spray gun which can be automatically controlled by a robot. When an area of a circuit board requires an insulative coating, a first mode is preferably operated to apply an atomized coating of insulative material preferably having a thickness of about 0.5 mils (0.0127 mm) to about 5 mils (0.127 mm). However, whenever the area being sprayed is directly next to a region which is to be left uncoated, the system is switched into the second mode whereby a nonatomized bead of coating material is applied. While the coating from the second mode is thicker, i.e. about 5 mils (0.127 mm) to about 10 mils (0.254 mm), than otherwise desired, it is typically only applied to a small, confined area and the overall coating process is economical.

In a second embodiment, the spray nozzle 76 is replaced with a spray nozzle 120, as shown in Fig. 5, which is identical to nozzle 76 except for the omission of elongated nozzle tip 87 from nozzle head 86. The coating system 10 operates with spray nozzle 120 as described in the first embodiment except for the coating material flowing through throughbore 88' and discharging from discharge outlet 90' of nozzle head 86'. As with the first embodiment, air jets are directed through air bores 100' substantially tangential to the outer periphery of the bead of coating material discharged from nozzle head 86'. Throughout the specification primed numbers represent structural elements which are substantially identical to structural elements represented by the same unprimed number.

While the system has been described with reference to using jets of air, it is also within the terms of the invention to use any type of desired gas.

### SOFT SWIRL MODE OF OPERATION

As discussed hereinabove, the coating system 10 is operable in two modes of operation, a first mode dispensing a conical spray of atomized coating material and a second mode dispensing a bead of nonatomized coating material to selectively dispense a conformal (e.g., protective) coating on substrates such as circuit boards.

When applying coating materials to a substrate such as a circuit board, it is important that the transfer efficiency be as high as possible, and there are challenges associated with applying coating material adjacent components on the circuit board.

A particularly advantageous feature of the coating system is that it is operable in an additional third mode of operation, and can be switched between any of the three modes of operation on the fly (while coating a single substrate).

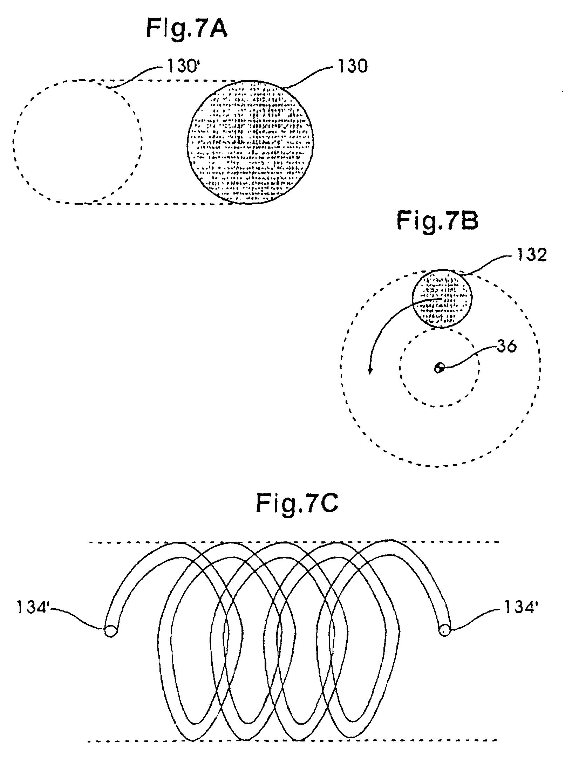

Fig. 7A illustrates a pattern of coating material generated on a substrate in the first (atomizing) mode, discussed hereinabove. As the spray gun (not shown) is moved linearly along the surface of the substrate, a completely filled-in circular pattern of coating material is applied from a first position 130 (shown in solid lines) to a second position 130' (shown in dashed lines) displaced from the first position. As discussed above, the first (atomizing) mode is suitably initiated by at least 68.947 kPa (10 psi) of air pressure.

In the second (bead) mode, a bead of coating material is laid down on the substrate while the spray gun is moved linearly along the surface of the substrate.

In the third (soft swirl) mode of operation, air pressure in the range of from 27.579 kPa (4 psi) to 68.947 kPa (10 psi) is provided, which is sufficient to direct the coating material to a sequence of selected positions on the substrate, but not to atomize it.

Fig. 7B illustrates the coating pattern that will result from the spray gun being operated in the third (soft swirl) mode when the spray nozzle is not moving with respect to the substrate. This results in a coating pattern of a small, filled-in circle 132 of coating material which moves around the centerline 36 of the spray nozzle 76. The path of the coating material is shown in dashed lines. This would result in a donut-shaped area of coating coverage on the substrate, with a void area.

Fig. 7C illustrates the result that would accrue in the third (soft swirl) mode of operation when the spray gun is moving linearly along the surface of the substrate, from a first position 134 (shown in solid lines) to a 134' second position (shown in dashed lines) displaced from the first position. Depending on the speed that the spray gun is moving along the surface of the substrate, this will result in a sinusoidal or overlapping loop (soft swirl) pattern of coating material on the substrate. Such a soft swirl application of coating material (third mode) exhibits 100% transfer efficiency, without atomizing the coating material, and is generally preferred when applying coating material adjacent components on the circuit board substrate. The pattern of coating material deposited onto the substrate in the third (soft swirl) mode of operation is comparable to the spiral patterns of adhesive created by the nozzles in commonly-owned U.S. Patent No. 4,969,602 issued November 13, 1990, and in commonly-owned U.S. Patent No. 5,194,115 issued March 16, 1993.

There has thus been described a coating system with three modes of operation: a first pressure-assisted (at least 10 psi (68.947 kPa)) mode wherein coating material is applied as an atomized conical spray pattern onto the substrate; a second non-pressurized mode wherein a bead of coating material is applied onto the substrate; and a third pressure-assisted (at least 4 (27.579) and less than 10 psi (68.947 kPa)) mode wherein coating material is applied in a soft swirl pattern onto the substrate without being atomized. These three modes may selectively be initiated and employed during the coating of a single substrate to deposit highly conformal coatings on selected areas of the substrate, without waste, thereby minimizing on the expense associated with the coating material. Different areas of the substrate can be coated with the spray gun operating in any one of the three modes.

### SLIM SWIRL

In the coating system 10 described hereinabove, the valve shaft 18 reciprocates between an open, retracted position, as shown in Fig. 1, in which its lower end disengages from valve seat 24, and an extended closed position in which the lower end of the valve shaft 18 engages seat 24 and blocks the discharge outlet 28.

When the discharge outlet 28 is closed off, there is a residual amount of coating material disposed in the volume of the throughbore 34. It has been observed that, when the discharge outlet 28 is subsequently opened (i.e., when the valve shaft 18 disengaged from the valve seat 24), the spray nozzle 76 will drip and dribble coating material upon startup.

It is thus desirable to minimize such drip and dribble upon startup.

To this end, the spray nozzle is preferably disposed in close proximity to the valve seat, thereby minimizing the volume of residual coating material present in the throughbore, and consequently minimizing or substantially eliminating drip and dribble during startup.

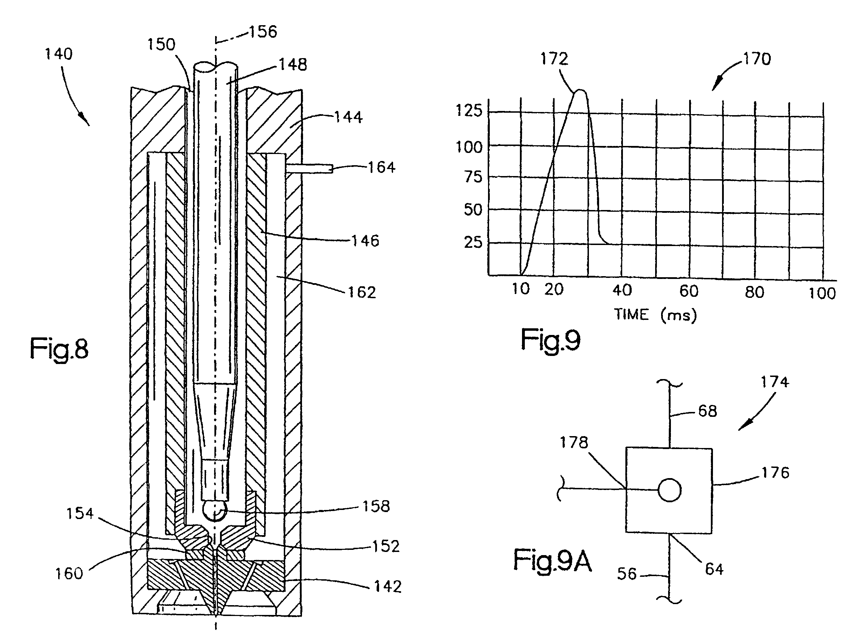

Fig. 8 illustrates a relevant portion of a coating system 140, similar to the coating system 10. Certain common elements between the coating system 140 and the coating system 10 are referred to by their numbers (in parentheses) associated with the coating system 10, for illustrative clarity.

In this embodiment, the spray nozzle 142 is disposed at the end of and is an integral part of the barrel 144 (compare 12). The spray nozzle 142 has air jet bores (100) terminating in outlet openings (105), and has an inlet end (92), a throughbore (88) and a discharge outlet (90), and may be provided with a tube (104) in the manner described hereinabove with respect to the spray nozzles 76 and 87. For purposes of the following discussion, the spray nozzle 142 is identical to the spray nozzle 76.

In this embodiment of a coating system 140, a cylindrical member 146 is disposed within the barrel 144, and the valve shaft 148 (compare 18) is disposed within the cylindrical member 146. The cylindrical member 146 has a throughbore 150 (compare 16) which functions as a fluid delivery passageway. The valve seat 152 (compare 24) is disposed at the end of the cylindrical member 146.

The valve shaft 148, cylindrical member 146, barrel 144, valve seat 152 and spray nozzle 142 are all concentric about a vertical centerline 156 (compare 36).

In use, the valve shaft 148 reciprocates between an open, retracted position, as shown in Fig. 8, in which its lower end disengages from valve seat 152 and opens a discharge outlet 154 (compare 28) therein, and an extended closed position (not shown) in which the lower end of valve shaft 148 engages the valve seat 152 and blocks the discharge outlet 154. The opening and closing of the discharge outlet 154 controls the flow of coating material through the liquid delivery passageway 150 to the spray nozzle 142 for deposition onto a substrate 11, such as a circuit board. In this embodiment, a ball 158 is affixed, such as by brazing, to the lower end of the valve shaft 128 and seals in the extended closed position of the valve shaft 148 against the discharge outlet 154 of the valve seat 152.

The overall construction of the coating system 140 including a spray gun, a source of air and a source of coating material forms no part of this invention per se and is described only briefly herein. The spray gun is operated by a conventional robot which controls the movement of the spray gun in the x, y and z axes.

In this embodiment of a coating system 140, the spray nozzle 142 is disposed closely adjacent the valve seat 152, thereby essentially eliminating residual coating material accumulating in a volume between the valve seat 152 and the spray nozzle 142. The spray nozzle 142 has a boss (84) on its upper surface (80) which fits into a corresponding counterbore (48) on the lower surface of the valve seat 152. To ensure a good seal between the spray nozzle 142 and the valve seat 152, a washer 160 is disposed between the upper surface of the spray nozzle 142 and the lower surface of the valve seat 152. The washer 160 has an inner diameter sufficiently large to fit around the boss on the upper surface of the spray nozzle 142 and an outer diameter which is sufficiently small so as not to block the inlet openings (103) of the air jet bores (100).

In this embodiment of a coating system 140, an air delivery passageway 162 (compare 52) is formed between the outer surface of the cylindrical member 146 and the inner surface of the barrel 144. An upper end of the air passage 162 is sealed off. A lower end of the air delivery passageway 162 is in flow communication with the air jet bores (100) in the spray nozzle 142. Pressurized air is provided to the air passage from any suitable source (not shown), such as has been described hereinabove, through an air inlet 164 extending through the barrel 144 into the air passage 162, so that the coating system 140 may operate in any of the three modes of operation described herein.

### ELIMINATING PRESSURE TRANSIENTS

Coating systems operating in various modes of operation, including selectively providing pressurized air (in the first and third modes of operation) and not providing pressurized air (in the second mode of operation) have been described hereinabove. It has been observed that upon initiating a mode which includes providing air pressure, that there is a startup pressure spike which may be up to approximately six (6) times the desired flow rate. This can result in undesirable splatter of coating material on the substrate.

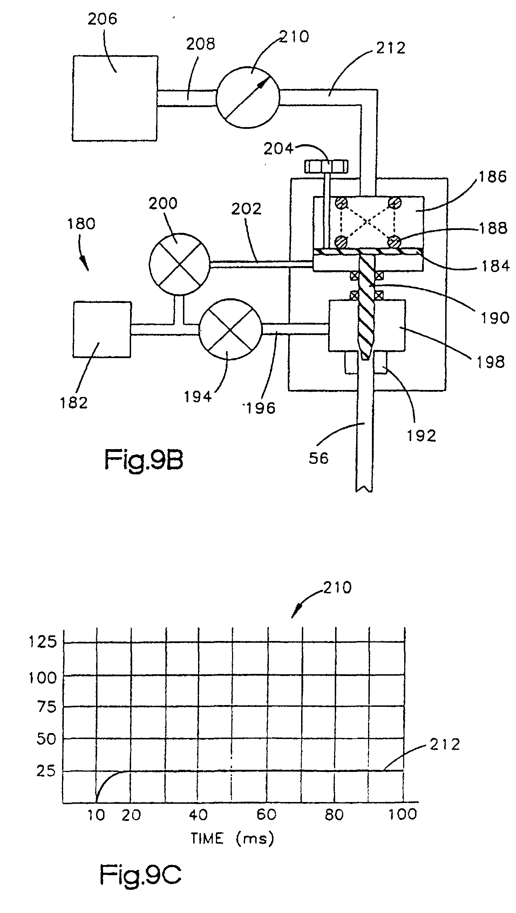

Fig. 9 is a graph illustrating the aforementioned problem of pressure spikes occurring when initiating a mode which includes providing air pressure. The x-axis is time, and the y-axis is pressure). This graph 170 illustrates that it is desired to provide the spray gun with 25 units (e.g., 25psi (172.37 kPa)) of air pressure, commencing at 10 milliseconds (10ms) from an initial pressure of 0 psi at t0. As is illustrated by the line 172, a pressure spike commences at 10ms and continues upward in excess of 125 psi (861.84 kPa) in the interval between 10ms and approximately 27ms. Then, between 27ms and approximately 35ms the pressure settles down to the desired 25 psi (172.37 kPa) flow rate to operate the spray gun in a pressure-assisted mode (e.g., in the first atomizing mode). It is thus evident that there is a startup pressure spike, lasting 15ms from startup, which may be up to approximately six (6) times the desired flow rate. This can result in undesirable splatter of coating material on the substrate. What is needed is a technique for providing a soft start upon initiating a pressure-assisted mode of operation, in other words for substantially reducing or eliminating pressure spikes attendant initiating a pressure-assisted mode.

In one soft start technique, the airflow (pressure) being directed to the spray gun is directed by a valve to an exhaust port in a noncoating mode (or in the second, non-pressurized, non-atomizing, bead coating mode) so that a static-to-dynamic pressure change does not occur upon initiating dispensing the coating material or initiating a pressure-assisted mode of operation (i.e., the first atomizing or third soft swirl operating modes described hereinabove). When the pressure-assisted mode(s) is (are) enabled, a valve simply redirects the airflow to the coating gun rather than to the exhaust port.

Fig. 9A illustrates an embodiment 174 of a soft start technique, wherein the airflow (pressure) being directed to the spray gun is directed by a valve 176 to an exhaust port over a line 178 in a noncoating mode (or in the second, non-pressurized, non-atomizing, bead coating mode) so that a static-to-dynamic pressure change does not occur upon initiating a pressure-assisted mode of operation. When the pressure-assisted mode(s) is (are) enabled, the valve 176 simply redirects the airflow through an outlet port 64 (see Fig. 1) to the coating gun, over the line 56 (see Fig. 1) rather than to the exhaust port 178. The valve 176 is suitably a solenoid actuated valve and is connected by an air line 68 to a source of pressurized gas, typically air. Opening and closing the valve 176 by an external control (not shown), controls the air jets impinging against the coating material being discharged from the nozzle (76, 142).

Fig. 9B illustrates another embodiment 180 of a soft start technique for eliminating pressure spikes when switching on airflow from a supply 182 of pressurized gas, typically air, to the spray gun over a line 56. Generally, a fluid damping system is provided having the following major components and construction.

A piston 184 is disposed within a cylindrical chamber 186. A spring 188 is disposed atop the piston 184 and a rod 190 extends from the lower surface of the piston 184. The lower (as viewed) end of the rod 190 is suitably shaped (e.g., tapered) to seal against an inlet side of an orifice in a valve seat 192. The rod 190 is illustrated in its "closed" position, against the valve seat 192, and is biased to the closed position by the spring 188 exerting a downward (as viewed) closing force on the piston 184. The line 56 is connected to an outlet side of the valve seat 192.

Pressurized air from the source 182 of pressurized gas is regulated by an air regulator 194, and is provided over a line 196 to a chamber 198 adjacent the valve seat. In this manner, when the rod 190 is in its "open" position (not shown), regulated pressurized air from the source 182 of pressurized gas can flow through the line 56 to the spray gun.

The rod 190 is shown in its closed position, and is moved upward to its open position in any suitable manner such as by providing sufficient air pressure to the bottom side of the piston 184 to overcome the closing force of the spring 188. To this end, a solenoid valve 200 receives unregulated (prior to being regulated by the regulator 194) air pressure from the source 182 of pressurized gas, and an outlet of the solenoid valve 200 is connected via a line 202 to a portion of the cylindrical chamber 186 which is underneath the piston 184. The solenoid valve 200 is switched on (opened) and off (closed) in a manner similar to that in which the opening and closing of the valve 66 was controlled (i.e., by an external control, not shown). The upward stroke of the piston 184 is limited by a set screw 204, such as a thumb screw) entering the top of the cylindrical chamber 186 and acting against the top surface of the piston 184.

Movement of the rod 190 from its closed position to its open position is dampened, in the following manner. The portion of the cylindrical chamber 186 atop the piston 184 is filled with fluid (not shown), such as hydraulic oil which is supplied from an oil reservoir 206. The oil reservoir 206 is connected to the chamber 186 via a line 208 to a flow control valve (orifice) 210, and via a line 212 from the flow control valve 210 to the chamber 186. Damping is effected by the flow control valve 210 restricting the free flow of oil back and forth between the chamber 186 and the reservoir 206. The flow control valve 210 is adjustable, to control the amount of damping exerted on the movement of the piston 184.

In this manner, when a pressure-assisted mode is enabled, unregulated air pressure moves the piston 184 and rod 190 to an open position, regulated air pressure is provided over the line 56 to the spray gun, and pressure transients are absorbed by the damping mechanism of the oil moving through the flow control valve 210 as the piston 184 moves upward, so that the aforementioned pressure transients and splatter are avoided when operating the spray gun in a pressure-assisted mode.

Fig. 9C is a graph illustrating the results achieved by employing the soft start techniques of the embodiments 174 or 180 wherein the aforementioned problem of pressure spikes occurring when initiating a mode which includes providing air pressure is overcome. As with Fig. 9, the x-axis is time, and the y-axis is pressure). This graph 210 (compare 170) illustrates that it is desired to provide the spray gun with 25 units (e.g., 25 psi (172.37 kPa)) of air pressure, commencing at 10 milliseconds (10ms) from an initial pressure of 0 kPa of (0 psi) at t₀. As is illustrated by the line 212 (compare 172), in the interval between 10ms and approximately 18ms, the pressure rises smoothly to the desired exemplary 25 psi (172.37 kPa) flow rate to operate the spray gun in a pressure-assisted mode (e.g., in the first atomizing mode). It is thus evident that the problem of incurring a startup pressure spike, and attendant splatter of coating material upon startup, has substantially been reduced, if not entirely eliminated.

It is apparent that there has been provided apparatus and methods for coating selected areas of a circuit board with a liquid coating material without coating regions of the circuit board to be left uncoated that satisfy the objects, means and advantages set forth hereinbefore. In one mode of operation of a first embodiment, a bead of liquid coating material dispensed from an elongated nozzle tip is atomized by directing jets of air against the bead to form a conical, swirling spray pattern which is sprayed on selected areas of a circuit board where overspray is not a significant concern. In a second mode, the non-atomized bead of liquid coating material dispensed through the elongated nozzle tip is applied on selected areas of the circuit board where overspray cannot be tolerated. In a second embodiment, a first mode operates by dispensing the bead of liquid coating material from a nozzle without the elongated nozzle tip and atomizing the bead of material by directing jets of air against the bead to form a conical, swirling spray pattern which is sprayed on selected areas of a circuit board where overspray is not a significant concern. In a second mode of the second embodiment, the bead of liquid coating material dispensed from the nozzle without the elongated nozzle tip is applied on selected areas of the circuit board where overspray cannot be tolerated.

## Claims

1. A system (10, 140) for spray coating a substrate (11) with a liquid coating material, comprising a liquid spray device having a liquid delivery passageway (16, 34, 150) for supplying liquid coating material and an air delivery passageway (52, 162) for supplying pressurized air, a nozzle (76, 120, 142) mounted to the liquid spray device having a discharge outlet (90, 90') at one end and having a throughbore (88, 88') in flow communication with the liquid delivery passageway (16, 34, 150) to discharge the liquid coating material as a bead of liquid coating material from the discharge outlet (90, 90'), the nozzle (76, 120, 142) including a plurality of air bores (100) in flow communication with the air delivery passage-way (52, 162) to direct pressurized air against the outer periphery of the bead of liquid coating material discharged from the discharge outlet (90, 90') to form the liquid coating material into an atomized spray pattern, and a controller operatively connected to the liquid spray device for selectively opening and closing the air delivery passageway (52, 162) of the liquid spray device whereby the bead of liquid coating material discharged from the discharge outlet (90, 90') is applied to the substrate (11) either as an atomized spray pattern or as a bead of the liquid, **characterised in that** the plurality of air bores (100) direct pressurized air such that the liquid coating material swirls within the atomized spray pattern.

2. A system as claimed in Claim 1 wherein the nozzle (76, 120, 142) is formed with at least six bores (100) in flow communication with the air delivery passage (52, 162), the air bores (100) being formed at an angle with respect to the throughbore (88, 88').

3. A system as claimed in either Claim 1 or Claim 2 wherein the nozzle (76, 120, 142) is formed with at least twelve air bores (100) in flow communication with the air delivery passage (52, 162).

4. A system as claimed in any preceding Claim wherein the discharge outlet (90) comprises an elongated nozzle tip (87) including a tube (104) extending outward from the nozzle (76), the tube (104) having a nozzle orifice (107) disposed at one end to discharge the liquid coating material as a bead of liquid coating material.

5. A system as claimed in Claim 4 wherein the nozzle (76) comprises an annular plate (78) with a first surface (80) on one side thereof, and a nozzle head (86) extending outwardly from a second surface (82) on a second opposite side of the plate (78), the plate (78) having the throughbore (88) extending between the said one side and the nozzle head (86) to receive the tube (104), and the plate (78) being formed with the air bores (100) extending between the first surface (80) and the second surface (82).

6. The system of any preceding Claim wherein the controller is adapted to control the pressurized air to selectively apply said liquid coating material as a swirling bead of said liquid.

7. The system of any preceding Claim wherein the controller selectively applies the liquid coating material using three selectable modes including bead pattern, swirling atomized pattern and swirling bead pattern.

8. The system of any preceding Claim wherein the controller applies liquid coating material to the substrate by selecting a spray pattern based on a predetermined configuration of the substrate.

9. A method of applying a liquid coating material to a substrate (11), comprising the steps of supplying liquid coating material through a liquid delivery passageway (16, 34, 150) of a liquid spray device and supplying pressurized air to an air delivery passageway (52, 162) of the liquid spray device, directing the liquid coating material from the liquid delivery passageway into a throughbore (88, 88') extending through a nozzle (76, 120, 142) mounted to the spray device terminating in a discharge outlet (90, 90') for discharging the liquid coating material as a bead of liquid coating material; selectively directing the pressurized air from the air delivery passageway (52, 162) into a plurality of air bores (100) formed in the nozzle (76, 120, 142) to operate the liquid spray device in three modes of operation: a first mode of operation wherein pressurized air flowing through the air bores (100) at a first pressure is directed against the outer periphery of the bead of liquid coating material to form a spray pattern of atomized liquid coating material for deposition on a substrate (11); a second mode of operation wherein no air is flowed through the air bores (100) and the liquid coating material is applied as a bead; and a third mode of operation wherein pressurized air flowing through the air bores (100) at a second pressure lower than the first pressure is directed against the outer periphery of the bead of liquid coating material to form a pattern of non-atomized liquid coating material for deposition on a substrate (11), **characterised in that** the method includes the step of directing the pressurized air to form a swirling spray pattern of atomized liquid coating material in the first mode of operation.

10. A method as claimed in Claim 9 wherein the first pressure is greater than 10 psi (68.947 kPa) and the second pressure is between 4 psi and 10 psi (27.579 and 68.947 kPa).

11. A method as claimed in either Claim 9 or Claim 10 including the step of directing the pressurized air against the outer periphery of the bead of liquid coating material to form a swirling spray pattern of atomized liquid coating material in the third mode of operation.

12. A method of applying a liquid coating material to a substrate, comprising the steps of supplying liquid coating material through a liquid delivery passageway (16, 134, 150) of a liquid spray device and supplying pressurized air from a source of pressurized air to an air delivery passageway (52, 162) of the liquid spray device, directing the liquid coating material from the liquid delivery passageway (16, 134, 150) into a throughbore (88, 88') extending through a nozzle (76, 120, 142) mounted to the spray device and terminating in a discharge outlet (90, 90') for discharging the liquid coating material as a bead of liquid coating material, selectively directing the pressurized air from the air delivery passageway (52, 162) into a plurality of air bores (100) formed in the nozzle (76, 120, 142) to operate the liquid spray device in at least two modes of operation: at least one pressure-assisted mode of operation wherein pressurized air flows through the air bores (100) and is directed against the outer periphery of the bead of liquid coating material; and a non-pressure-assisted mode of operation wherein no air flows through the air bores (100), in each of the at least two modes of operation, intermittently opening and closing the air delivery passageway (52, 162) of said liquid spray device whereby the bead of liquid coating material being discharged from the discharge orifice is applied to the substrate either as an atomized spray pattern, a non-atomized spray pattern or as a bead, and disposing a fluid damping system (174, 180) in a line between the supply of pressurized air and the air delivery passageway (52, 162) of the liquid spray device, the method includes the step of directing the pressurized air to form a swirling spray pattern of atomized liquid coating material in the first mode of operation.

## Patentansprüche

1. System (10, 140) zum Sprühbeschichten eines Substrates (11) mit einem flüssigen Beschichtungsmaterial, umfassend eine Flüssigkeitssprüheinrichtung mit einem Flüssigkeitszuleitungskanal (16, 34, 150) zum Zuführen von flüssigem Beschichtungsmaterial und einem Luftzuleitungskanal (52, 162) zum Zuführen von Druckluft, eine an der Flüssigkeitssprüheinrichtung befestigte Düse (76, 120, 142) mit einer Austragsöffnung (90, 90') an einem Ende und einer mit dem Flüssigkeitszuleitungskanal (16, 34, 150) in Strömungsverbindung stehenden Durchgangsbohrung (88, 88') zum Austragen des flüssigen Beschichtungsmateriales als eine Raupe aus flüssigem Beschichtungsmaterial aus der Austragsöffnung ((90, 90'), wobei die Düse (76, 120, 142) eine Vielzahl mit dem Luftzuleitungskanal (52, 162) in Strömungsverbindung stehende Luftbonrungen (100) umfasst, um zur Umformung des flüssigen Beschichtungsmateriales in ein Zerstäubungssprühmuster Druckluft gegen den Außenrand der aus der Austragsöffnung (90, 90') ausgetragenen Raupe aus flüssigem Beschichtungsmaterial zu richten, und eine Steuereinrichtung zum selektiven Öffnen und Schließen des Luflzuleitungskanales (52, 162) der Flüssigkeitssprüheinrichtung, die funktionell mit der Flüssigkeitssprüheinrichtung verbunden ist, wodurch die aus der Austragsöffnung (90, 90') ausgetragene Raupe aus flüssigem Beschichtungsmaterial entweder als ein Zerstäubungssprühmuster oder als eine Raupe der Flüssigkeit auf das Substrat (11) aufgebracht wird, **dadurch gekennzeichnet, dass** die Vielzahl Luftbohrungen (100) die Druckluft so lenkt, dass das flüssige Beschichtungsmaterial in dem Zerstäubungssprühmuster wirbelt.

2. System gemäß Anspruch 1, bei dem die Düse (76, 120, 142) mit mindestens sechs mit dem Luftzuleitungskanal (52, 162) in Strömungsverbindung stehenden Bohrungen (100) ausgebildet ist, wobei die Luftbohrungen (100) in Bezug auf die Durchgangsbohrung (88, 88') in einem Winkel ausgebildet sind.

3. System gemäß Anspruch 1 oder 2, bei dem die Düse (76, 120, 142) mit mindestens zwölf mit dem Luftzuleitungskanal (52, 162) in Strömungsverbindung stehenden Luftbohrungen (100) ausgebildet ist.

4. System gemäß einem der vorhergehenden Ansprüche, bei dem die Austragsöffnung (90) aus einer verlängerten Düsenspitze (87) besteht, die ein sich von der Düse (76) nach außen erstreckendes Rohr (104) umfasst, wobei das Rohr (104) eine an einem Ende angeordnete Düsenöffnung (107) besitzt, um das flüssige Beschichtungsmaterial als eine Raupe aus flüssigem Beschichtungsmaterial auszutragen.

5. System gemäß Anspruch 4, bei dem die Düse (76) aus einer Ringplatte (78) mit einer ersten Fläche (80) auf ihrer einen Seite, und einem sich von einer zweiten Fläche (82) auf einer zweiten, gegenüberliegenden Seite der Platte (78) nach außen erstreckenden Düsenkopf (86) besteht, wobei die Platte (78) die Durchgangsbohrung (88) aufweist, die sich zwischen der einen Seite und dem Düsenkopf (86) erstreckt, um das Rohr (104) aufzunehmen, und die Platte (78) mit den sich zwischen der ersten Fläche (80) und der zwelten Fläche (82) erstreckenden Luftbohrungen (100) ausgebildet ist.

6. System gemäß einem der vorhergehenden Ansprüche, bei dem die Steuereinrichtung angepasst ist, um die Druckluft für den selektiven Auftrag des flüssigen Beschichtungsmateriales als eine wirbelnde Raupe der Flüssigkeit zu steuern.

7. System gemäß einem der vorhergehenden Ansprüche, bei dem die Steuereinrichtung das flüssige Beschichtungsmaterial selektiv unter Nutzung von drei auswählbaren Betriebsmodi aufträgt, umfassend ein Raupenmuster, ein wirbelndes Zerstäubungsmuster und ein wirbelndes Raupenmuster.

8. System gemäß einem der vorhergehenden Ansprüche, bei dem die Steuereinrichtung das flüssige Beschichtungsmaterial durch Auswahl eines Sprühmusters basierend auf einer vorgegebenen Konfiguratioin des Substrates auf das Substrat aufträgt.

9. Verfahren zum Auftragen von flüssigern Beschichtungsmaterial auf ein Substrat (11), umfassend die Schritte des Zuführens von flüssigem Beschichtungsmaterial durch einen Flüssigkeitszuleitungskanal (16, 34, 150) einer Flüssigkeitssprüheinrichtung und Zuführens von Druckluft zu einem Luftzuleitungskanal (52, 162) der Flüssigkeitssprüheinrichtung, Leitens des flüssigen Beschichtungsmateriales aus dem Flüssigkeitszuleitungskanal in eine Durchgangsbohrung (88, 88'), die sich durch eine in einer Austragsöffnung (90, 90') an der Sprüheinrichtung befestigte Düse (76, 120, 142) zum Austragen des flüssigen Beschichtungsmateriales als eine Raupe aus flüssigem Beschichtungsmaterial erstreckt; selektiven Leitens der Druckluft aus dem Luftzuleitungskanal (52, 162) in eine Vielzahl von in der Düse (76, 120, 142) ausgebildeten Luftbohrungen (100) zum Betreiben der Flüssigkeitssprüheinrichtung in drei Betriebsmodi: einem ersten Betriebsmodus, in dem zum Ausbilden eines Sprühmusters aus zerstäubtem flüssigen Beschichtungsmaterial zum Auftrag auf ein Substrat (11) mit einem ersten Druck durch die Luftbohrungen (100) strömende Druckluft gegen den Außenrand der Raupe aus flüssigem Beschichtungsmaterial gerichtet wird; einem zweiten Betriebsmodus, in dem keine Luft durch die Luftbohrungen (100) strömt und das flüssige Beschichtungsmaterial als eine Raupe aufgetragen wird; und einem dritten Betriebsmodus, in dem zum Ausbilden eines Musters aus nicht zerstäubtem flüssigen Beschichtungsmaterial zum Auftrag auf ein Substrat (11) mit einem zweiten Druck, der geringer ist als der erste Druck, durch die Luftbohrungen strömende Druckluft gegen den Außenrand der Raupe aus flüssigem Beschichtungsmaterial gerichtet wird, **dadurch gekennzeichnet, dass** das Verfahren den Schritt des Richtens der Druckluft zum Ausbilden eines wirbelnden Sprühmusters des zerstäubten flüssigen Beschichtungsmateriales im ersten Betriebsmodus umfasst.

10. Verfahren gemäß Anspruch 9, bei dem der erste Druck größer ist als 10 psi (68,947 kPa) und der zweite Druck zwischen 4 psl und 10 psi (27,579 und 68,947 kPa) liegt.

11. Verfahren gemäß Anspruch 9 oder 10, umfassend den Schritt des Richtens der Druckluft gegen den Außenrand der Raupe aus flüssigem Beschichtungsmaterial zum Ausbilden eines wirbelnden Sprühmusters aus zerstäubtem flüssigen Beschichtungsmaterial im dritten Betriebsmodus.

12. Verfahren zum Auftragen von flüssigem Beschichtungsmaterial auf ein Substrat, umfassend die Schritte des Zuführens von flüssigem Beschichtungsmaterial durch einen Flüssigkeitszuleitungskanal (16, 34, 150) einer Flüssigkeitssprüheinrichtung und Zuführens von Druckluft von einer Druckluftquelle zu einem Luftzuleitungskanal (52, 162) der Flüssigkeitssprüheinrichtung, Leitens des flüssigen Beschichtungsmateriales aus dem Flüssigkeitszuleitungskanal (16, 134, 150) in eine Durchgangsbohrung (88, 88'), die sich durch eine an der Sprüheinrichtung befestigte und an einer Austragsöffnung (90, 90') endende Düse (76, 120, 142) zum Austragen des flüssigen Beschichtungsmateriales als eine Raupe des flüssigen Beschichtungsmateriales erstreckt, selektiven Leitens der Druckluft aus dem Luftzuleitungskanal (52, 162) in eine Vielzahl von in der Düse (76, 120, 142) ausgebildeten Luftbohrungen (100) zum Betreiben der Flüssigkeitssprüheinrichtung in mindestens zwei Betriebsmodi: mindestens einem druckunterstützten Betriebsmodus, in dem Druckluft durch die Luftbohrungen (100) strömt und gegen den Außenrand der Raupe aus flüssigem Beschichtungsmaterial gerichtet wird; und einem nichtdruckunterstützten Betriebsmodus, in dem keine Luft durch die Luftbohrungen (100) strömt, mit intermittierendem Öffnen und Schließen des Luftzuleitungskanales (52, 162) der Flüssigkeitssprüheinrichtung in jedem der mindestens zwei Betriebsmodi, wodurch die aus der Austragsöffnung ausgetragene Raupe aus flüssigern Beschichtungsmaterial entweder als ein Zerstäubungssprühmuster, ein nichtzerstäubtes Sprühmuster oder als eine Raupe auf das Substrat aufgetragen wird, und Anordnens eines Flüssigkeitsdämpfungssystems (174, 180) in einer Leitung zwischen der Druckluftzuführung und dem Luftzuleitungskanal (52, 162) der Flüssigkeitssprüheinrichtung, wobei das Verfahren den Schritt des Richtens der Druckluft zum Ausbilden eines wirbelnden Sprühmusters des zerstäubten flüsslgen Beschichtungsmateriales im ersten Betriebsmodus umfasst.

## Revendications

1. Système (10, 140) destiné à revêtir un support (11) avec un liquide de revêtement comprenant un dispositif de pulvérisation de liquide présentant un passage d'alimentation de liquide (16, 34, 150) pour fournir une substance de revêtement liquide et un passage d'alimentation d'air (52, 162) pour fournir de l'air comprimé, une buse (76, 120, 142) montée sur le dispositif de pulvérisation de liquide présentant un orifice de refoulement (90, 90') à une extrémité et ayant un alésage passant (88, 88') en communications liquide avec le passage d'alimentation en liquide (16, 34, 150) pour refouler la substance de revêtement liquide en tant que perle de substance de revêtement liquide provenant de l'orifice de refoulement (90, 90'), la buse (76, 120, 142) comprenant une pluralité d'alésages d'air (100) en communication fluide avec le passage de refoulement d'air (52, 162) pour diriger l'air comprimé sur la périphérie extérieure de la perle de substance de revêtement liquide libérée par l'orifice de refoulement (90, 90') pour transformer la substance de revêtement liquide en une forme de pulvérisation atomisée et un régulateur relié fonctionnellement au dispositif de pulvérisation de liquide pour ouvrir et fermer de manière sélective le passage d'alimentation en air (52, 162) du dispositif de pulvérisation de liquide moyennant quoi la perle de substance de revêtement liquide refoulée par l'orifice de refoulement (90, 90') est appliqué sur le support (11) soit sous la forme d'une pulvérisation atomisée, soit en tant que perle de liquide, **caractérisé en ce que** la pluralité d'alésages d'air (100) dirige l'air comprimé de manière à ce que la substance de revêtement liquide tourbillonne à l'intérieur de la forme de pulvérisation atomisée

2. Système selon la revendication 1, dans lequel la buse (76, 120, 142) est constituée avec au moins six alésages (100) en communication fluide avec le passage d'alimentation en air (52, 162), les alésages (100) étant constitués à un angle par rapport à l'alésage passant (88, 88').

3. Système selon la revendication 1 ou 2, dans lequel la buse (76, 120, 142) est constituée avec au moins douze alésages d'air (100) en communication fluide avec le passage d'alimentation en air (52, 162).

4. Système selon l'une quelconque des revendications précédentes, dans lequel l'orifice de refoulement (90) présente un embout de buse allongé (87) comprenant un tube (104) s'étendant vers l'extérieur à partir de la buse (76), le tube (104) présentant un orifice de buse (107) situé à une extrémité pour refouler la substance de revêtement liquide en tant que perle de substance de revêtement liquide.

5. Système selon la revendication 4, dans lequel la buse (76) comprend une plaque annulaire (78) avec une première surface (80) sur un côté de celle-ci et une tête de buse (86) s'étendant vers l'extérieur à partir d'une seconde surface (82) sur un second côté opposé de la plaque (78), la plaque (78) présentant un alésage passant (88) s'étendant entre ledit un côté de la tête de buse (86) pour recevoir le tube (104) et la plaque (78) étant constituée avec les alésages d'air (100) s'étendant entre la première surface (80) et la seconde surface (82).

6. Système selon l'une quelconque des revendications précédentes, dans lequel le régulateur est adapté pour contrôler l'air comprimé pour appliquer de manière sélective ladite substance de revêtement liquide en tant que perle tourbillonnante dudit liquide.

7. Système selon l'une quelconque des revendications précédentes, dans lequel le régulateur applique de manière sélective la substance de revêtement liquide en utilisant trois modes sélectionnables dont une forme en perle, une forme atomisée tourbillonnante et une forme en perle tourbillonnante.

8. Système selon l'une quelconque des revendications précédentes, dans lequel le régulateur applique la substance de revêtement liquide sur le support en sélectionnant une forme de pulvérisation fondée sur une configuration prédéterminée du support.

9. Procédé d'application d'une substance de revêtement liquide sur un support (11) comprenant les étapes consistant à fournir la substance de revêtement liquide par un passage d'alimentation (16, 34, 150) d'un dispositif de pulvérisation de liquide et à fournir de l'air comprimé à un passage d'alimentation en air (52, 162) du dispositif de pulvérisation de liquide, à diriger la substance de revêtement liquide du passage d'alimentation en liquide dans un alésage passant (88, 88') s'étendant au travers d'une buse (76, 120, 142) montée sur le dispositif de pulvérisation se terminant dans un orifice de refoulement (90, 90') pour refouler la substance de revêtement liquide en tant que perle de substance de revêtement liquide ; à diriger de manière sélective l'air comprimé provenant de passage d'alimentation en air (52, 162) dans une pluralité d'alésages d'air (100) constitués dans la buse (76, 120, 142) pour faire fonctionner le dispositif de pulvérisation en trois modes : un premier mode de fonctionnement dans lequel l'air comprimé passant par les alésages d'air (100) à une première pression est dirigé sur la périphérie extérieure de la perle de substance de revêtement liquide pour former une forme de pulvérisation de substance de revêtement liquide atomisée pour la déposer sur un support (11) ; un second mode de fonctionnement dans lequel aucun air ne passe par les alésages d'air (100) et la substance de revêtement liquide est appliquée en tant que perle et; un troisième mode de fonctionnement dans lequel l'air comprimé passant par les alésages d'air (100) à une seconde pression inférieure à la première pression est dirigé sur la périphérie extérieure de la perle de substance de revêtement liquide pour constituer une forme de substance de revêtement liquide non atomisée pour être déposée sur le support (11), **caractérisé en ce que** le procédé comprend les étapes consistant à diriger l'air comprimé pour constituer une forme de pulvérisation tourbillonnante de substance de revêtement liquide atomisé dans le premier mode de fonctionnement.

10. Procédé selon la revendication 9 dans lequel la première pression est supérieure à 10 psi (88,897 kPa) et la seconde pression est située entre 4 psi et 10 psi (27,579 et 68,947 kPa).

11. Procédé selon les revendications 9 ou 10 comprenant l'étape consistant à diriger l'air comprimé contre la périphérie extérieure de la perle de substance de revêtement liquide pour constituer une forme de pulvérisation tourbillonnante de substance de revêtement liquide atomisée dans le troisième mode de fonctionnement.

12. Procédé d'application d'une substance de revêtement liquide sur un support comprenant les étapes consistant à fournir une substance de revêtement liquide au travers d'un passage d'alimentation (16, 134, 150) d'un dispositif de pulvérisation de liquide et à fournir de l'air comprimé à partir d'une source d'air comprimé à un passage d'alimentation en air (52, 162) du dispositif de pulvérisation de liquide, à diriger la substance de revêtement liquide provenant du passage d'alimentation en liquide (16, 134, 150) dans un alésage passant (88, 88') s'étendant au travers d'une buse (76, 120, 142) montée sur le dispositif de pulvérisation et se terminant en orifice de refoulement (90, 90') pour refouler la substance de revêtement liquide de manière sélective, à diriger l'air comprimé provenant du passage d'alimentation en air (52, 162) dans une pluralité d'alésages (100) constitués dans la buse (76, 120, 142) pour faire fonctionner le dispositif de pulvérisation de liquide dans au moins deux modes de fonctionnement : au moins un mode de fonctionnement sous pression dans lequel l'air comprimé passe au travers des alésages (100) et est dirigé contre la périphérie extérieure de la perle de substance de revêtement liquide et ; un mode de fonctionnement hors pression dans lequel aucun air ne passe par les alésages d'air (100), dans chacun des deux modes au moins de fonctionnement, ouvrir et fermer de manière intermittente le passage d'alimentation en air (52, 162) du dispositif de pulvérisation de liquide, moyennant quoi la perle de substance de revêtement liquide refoulée par l'orifice de refoulement est appliquée sur un support soit en tant que forme de pulvérisation atomisée, soit en forme de pulvérisation non-atomisée ou en tant que perle et à disposer un système de mouillage en liquide (174, 180) en ligne entre l'alimentation en air comprimé et le passage d'alimentation en air (52, 162) du dispositif de pulvérisation de liquide, le procédé comprenant l'étape consistant à diriger l'air comprimé pour constituer une forme de pulvérisation tourbillonnante de substance de revêtement de liquide atomisé dans le premier mode de fonctionnement.
